Europäisches Patentamt

European Patent Office

Office européen des brevets

(11) Veröffentlichungsnummer: **0 199 231**
**B1**

(12) **EUROPÄISCHE PATENTSCHRIFT**

(45) Veröffentlichungstag der Patentschrift:
24.10.90

(21) Anmeldenummer: 86105065.6

(22) Anmeldetag: 14.04.86

(51) Int. Cl.⁵: **H01L 27/02**

(54) In CMOS-Technik aufgebaute Zelle.

(30) Priorität: 24.04.85 DE 3514849

(43) Veröffentlichungstag der Anmeldung:
29.10.86 Patentblatt 86/44

(45) Bekanntmachung des Hinweises auf die Patenterteilung:
24.10.90 Patentblatt 90/43

(84) Benannte Vertragsstaaten:
AT BE CH DE FR GB IT LI NL SE

(56) Entgegenhaltungen:
EP-A- 0 136 952

(73) Patentinhaber: Siemens Aktiengesellschaft,
Wittelsbacherplatz 2, D-8000 München 2(DE)

(72) Erfinder: Holzapfel, Heinz Peter, Dipl.-Phys.,
Blütenstrasse 14, D-8000 München 40(DE)
Erfinder: Michel, Petra, Dipl.-Phys., Voglherd 1,
D-8018 Grafing(DE)

**Beschreibung**

Die Erfindung bezieht sich auf eine in CMOS-Technik aufgebaute Zelle, bei der mindestens ein p-Kanal und mindestens ein n-Kanaltransistor vorgesehen sind, insbesondere zur Verwendung bei einem Gate-Array.

Es ist bekannt, zur schnellen Realisierung von kundenspezifischen Bausteinen mit vorgefertigten oder vorentwickelten Zellen aufgebaute Bausteine zu verwenden, bei denen die einzelnen Zellen entsprechend dem Kundenwunsch miteinander verbunden werden. Eine Möglichkeit ist die Verwendung von sog. Gate-Arrays, bei denen Transistorpaare in CMOS-Technik matrixförmig auf einem Baustein angeordnet sind. Solche Gate-Arrays sind z.B. beschrieben in "Elektronik", 19, vom 21.9.1984, S. 68 oder "VLSI-Design", Februar 1984, S. 78 bis 80.

Manchmal ist es schaltungstechnisch wünschenswert, wenn bei CMOS-Gate-Arrays flächensparenden Widerstände im Zellenbereich zur Verfügung stehen. Der Anwendungsbereich von Widerständen liegt insbesondere in der Festlegung von definierten Pegeln auf Sammelleitungen, Schreib- und Leseleitungen von Speichern und bei der Beschaltung von Laufzeitgliedern. Weiterhin ist es wünschenswert, zum Aufbau von dynamischen Speicherzellen und Laufzeitgliedern flächensparend aufgebaute Kapazitäten zur Verfügung zu haben. Dabei ist zu berücksichtigen, daß die aktiven Bereiche auf einem CMOS-Gate-Array eine fest definierte Struktur haben. Für die Kapazitäten und Widerstände können nur die nicht-kundenspezifischen Gates und Diffusionsgebiete der Grundzellen verwendet werden. Insbesondere für hochohmige Widerstände und Kapazitäten, die groß gegenüber der typischen Gate-Kapazität sind, muß eine unverhältnismäßig große Anzahl von Grundzellen des Gate-Arrays verwendet werden.

Die Realisierung von Widerständen und Kapazitäten unter Nutzung der bereits auf dem Gate-Array vorhandenen Diffusionsgebiete und Gates hat den Nachteil, daß ein unverhältnismäßig großer prozentualer Anteil der Grundzellen hierzu verwendet werden muß. Um dies zu vermeiden, ist bereits vorgeschlagen worden (EP A 0 136 956), eine Gate-Array-Anordnung mit zwei Arten von Grundzellen vorzusehen. Die erste Art von Grundzellen ist nach üblicher Art aufgebaut, die zweite Art hat gegenüber der ersten Art von Grundzellen eine kleinere Leitfähigkeit. Dies wird dadurch erreicht, daß die Länge der Kanäle der zweiten Grundzellen größer ist als die der ersten Grundzellen. Die Breite der Kanäle wird dagegen nicht verändert. Die Kanäle verlaufen dabei auf kürzestem Weg zwischen Source und Drain der Transistoren.

Die der Erfindung zugrundeliegende Aufgabe besteht darin, zur Realisierung von Widerständen und/oder Kapazitäten die Leitfähigkeit der Transistoren weiter zu verringern, ohne daß deswegen die geometrischen Abmessungen im Gate-Array geändert werden müssen.

Diese Aufgabe wird bei einer Zelle der eingangs angegebenen Art gemäß den Merkmalen des Kennzeichens des Patentanspruchs 1 gelöst.

Weiterbildungen der Erfindung ergeben sich aus den Unteransprüchen.

Der Vorteil der Erfindung liegt darin, daß im Gate-Array statt der Grundzellen üblicher Art die erfindungsgemäßen Zellen angeordnet werden können und dabei die Periodizität des Gate-Arrays nicht gebrochen wird. An jedem Platz einer Grundzelle kann dabei die erfindungsgemäße Zelle liegen. Wird die Zelle an den Seiten der Grundzellenstreifen angeordnet, dann ergibt sich daraus keine Beeinträchtigung des Entflechtungsprogrammes.

Anhand von Ausführungsbeispielen, die in den Figuren dargestellt sind, wird die Erfindung weiter erläutert. Es zeigen

Fig.1 die erfindungsgemäße Zelle,
Fig.2 einen ersten Schnitt durch die erfindungsgemäße Zelle,
Fig.3 einen zweiten Schnitt durch die erfindungsgemäße Zelle,
Fig.4 das Ersatzschaltbild der erfindungsgemäßen Zelle,
Fig.5 die Zelle bei Verwendung als Widerstand,
Fig.6 das Ersatzschaltbild der Zelle gemäß Fig.5,
Fig.7 die Zelle bei Verwendung als Kapazität,
Fig.8 das Ersatzschaltbild der Zelle nach Fig.7,
Fig.9 die Zelle bei Verwendung als Abschlußwiderstand einer Sammelleitung,
Fig.10 das Ersatzschaltbild dieser Zelle nach Fig.9,
Fig. 11 ein Ersatzschaltbild der Zelle bei Verwendung als RC-Glied,
Fig. 12 die Zelle bei Verwendung als Inverter,
Fig. 13 das Ersatzschaltbild der Zelle nach Fig. 12,
Fig. 14 die Anordnung der Zelle in einem Gate-Array.

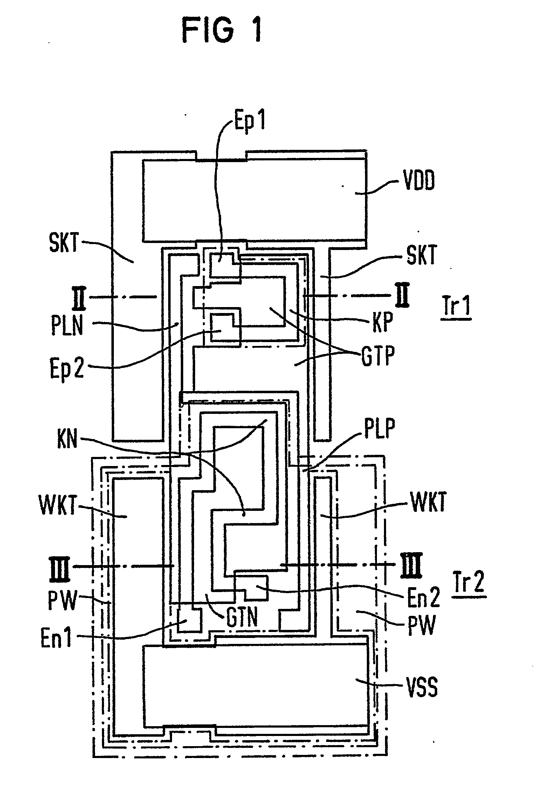

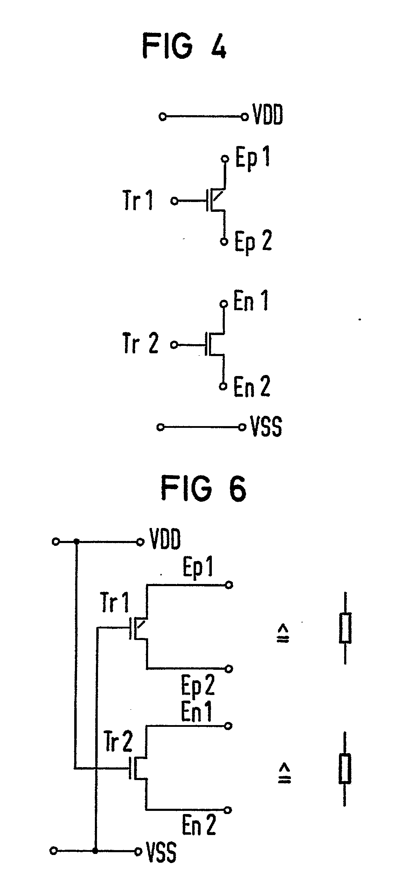

Fig.1 zeigt das Layout der Zelle. Gemäß Fig.4 sind in der Zelle zwei Transistoren Tr1 und Tr2 vorgesehen, wobei der Transistor Tr1 als p-Kanaltransistor und der Transistor Tr2 als n-Kanaltransistor realisiert ist. Drain und Source des Transistors Tr1 sind mit Ep1 und Ep2, des Transistors Tr2 mit En1 und En2 bezeichnet.

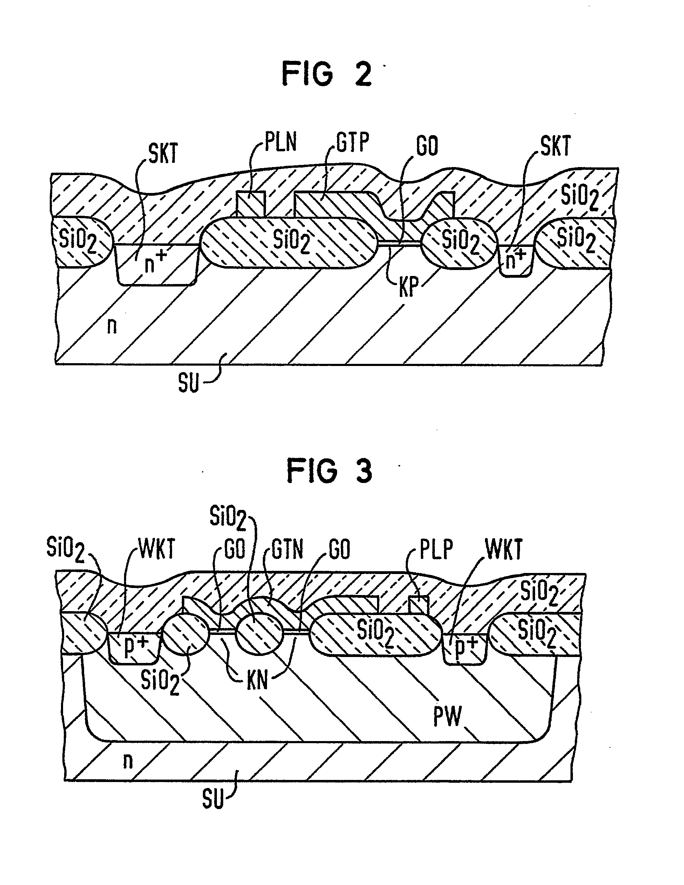

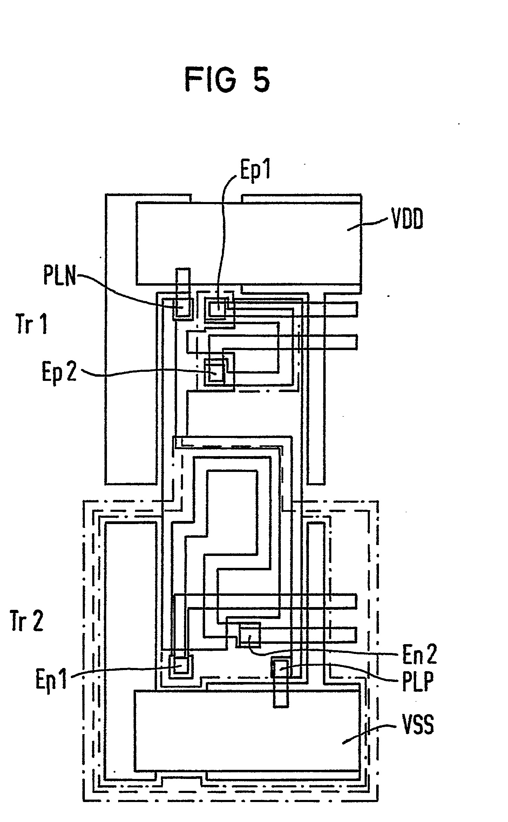

Durch das Layout der Zelle nach Fig.1 sind zwei Schnitte an den Stellen II-II und III-III gelegt, wie in den Fig. 2 und 3 dargestellt ist. Im oberen Teil des Layout nach Fig. 1 ist der Transistor Tr1 angeordnet. Drain und Source Ep1 und Ep2 sind gut erkennbar; weiterhin ist gut erkennbar, daß der Kanal KP des Transistors Tr1 seitlich zu Drain und Source Ep1 und Ep2 liegt. Das Gate GTP liegt über dem Kanal KP und ist mit einer Anschlußleitung PLP aus Polysilizium verbunden, die benachbart zum zweiten Transistor Tr2 angeordnet ist. Damit ist eine Verbindung des Transistors Tr1, und zwar des Gate, mit einer Betriebsspannung VSS, möglich.

Fig. 2 zeigt genauer den Aufbau des Transistors Tr1. In einem n-Substrat Su sind von links nach rechts fortschreitend ein Feldoxid $SiO_2$, ein $n^+$ Gebiet SKT ($n^+$ Substratkontakt), ein Feldoxid $SiO_2$, anschließend der Kanal KP, wiederum ein Feldoxid $SiO_2$, ein $n^+$ Gebiet SKT ($n^+$ Substratkontakt) und anschließend wiederum ein Feldoxid $SiO_2$ angeordnet. Über dem Kanal KP ist das Gateoxid GO angeordnet; darüber liegt das Gate GTP. Benachbart zum Gate GTP ist noch die Anschlußleitung PLN zum Gate des Transistors Tr2 angeordnet.

Die Realisierung der einzelnen Bereiche des Transistors Tr1 und deren Bedeutung ist bekannt und wird deshalb nicht weiter erläutert.

Der Aufbau des Transistors Tr2 entspricht dem des Transistors Tr1, bis auf die Ausnahme, daß dieser in einer p-Wanne PW angeordnet ist. Damit ist es möglich, einen n-Kanaltransistor zu realisieren. Wie der Schnitt nach Fig.3 zeigt, ist die Folge (von links beginnend) Feldoxid $SiO_2$, $n^+$ Bereich als Wannenkontakt, Feldoxid $SiO_2$, Kanal KN, Feldoxid $SiO_2$, $p^+$ Bereich als Wannenkontakt und wiederum Feldoxid $SiO_2$. Da der Kanal beim Transistor Tr2 anders gelegt ist als der Kanal beim Transistor Tr1, ist beim Schnitt III-III der Kanal KN durch ein Feldoxid $SiO_2$ unterbrochen. Auf dem Kanal KN ist das Gateoxid GO angeordnet, und darüber liegt das Gate GTN. Die Anschlußleitung für das Gate des Transistors Tr1 liegt benachbart zum Gate GTN und ist mit PLP bezeichnet. Auch beim Transistor Tr2 ist der Kanal KN im wesentlichen seitlich zu Source und Drain En1 und En2 angeordnet.

Benachbart zur Zelle liegen zwei Betriebsspannungen VDD und VSS. Mit diesen können zur Realisierung von Widerständen bzw. Kapazitäten Gate oder Drain bzw. Source verbunden werden.

Fig. 5 zeigt, wie mit Hilfe der Zelle ein Widerstandselement aufgebaut werden kann. Das Ersatzschaltbild dazu ist in Fig.6 dargestellt. Der Gate-Anschluß PLP des Transistors Tr1 wird mit der Betriebsspannung VSS verbunden; entsprechend wird der Gate-Anschluß PLN des Transistors Tr2 mit der Betriebsspannung VDD verbunden. Die Anschlüsse für Drain und Source Ep1 und Ep2 bzw. En1 und En2 bilden die Klemmen der Widerstände. Durch entsprechende Dimensionierung der Kanäle KP und KN können z.B. Widerstände von 500 k Ohm erreicht werden. Dazu haben die Kanäle KN und KP bei kleiner Breite eine verhältnismäßig große Länge. Fig. 1 zeigt dies sehr deutlich.

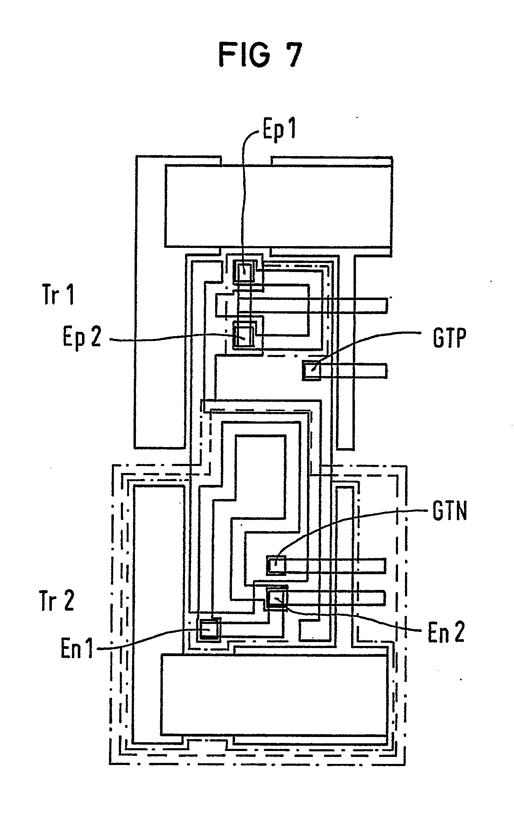

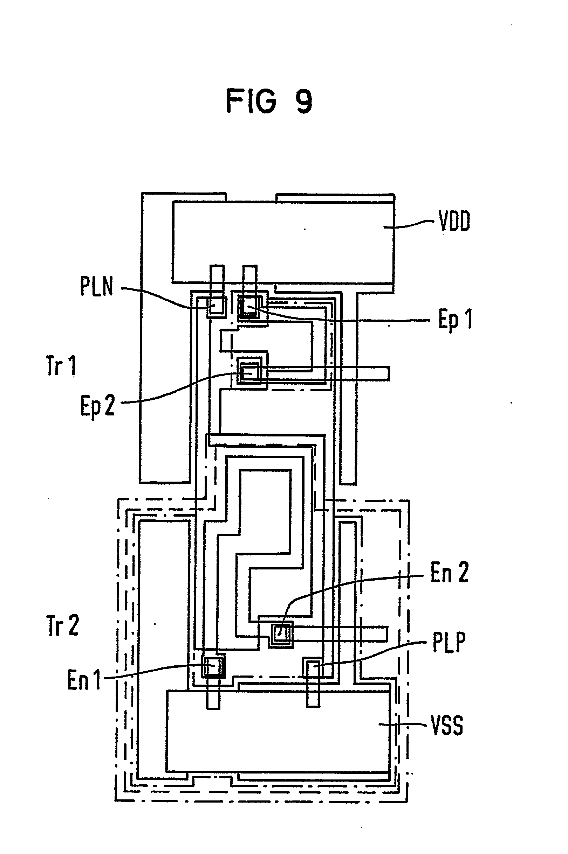

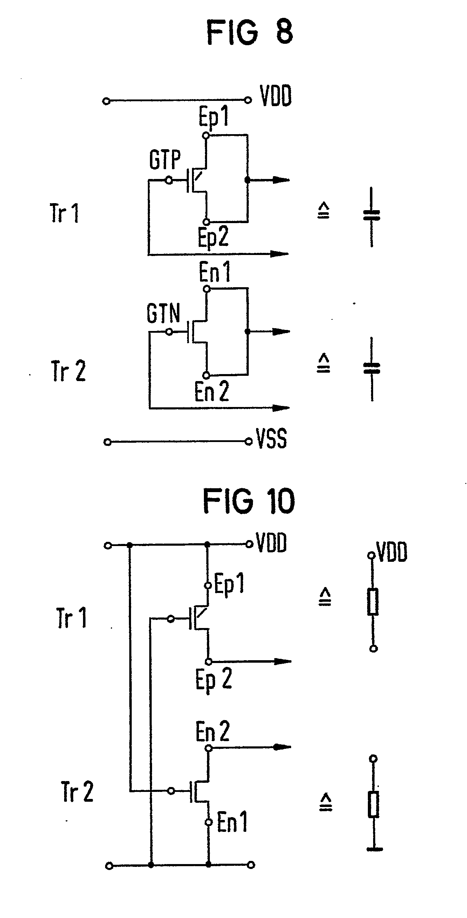

Die Realisierung der Zelle als Kapazität kann Fig. 7 entnommen werden, das Ersatzschaltbild dazu der Fig.8. Jetzt wird Drain und Source Ep1 und Ep2 bei Transistor Tr1 bzw. En1 und En2 bei Transistor Tr2 miteinander verbunden und bildet den einen Anschluß der Kapazität. Der andere Anschluß der Kapazität bildet jeweils das Gate GTP bzw. GTN der Transistoren Tr1 bzw. Tr2. Mit Hilfe der Zelle können z.B. Kapazitäten von 150 oder 420fF geschaffen werden.

Die Verwendung der Zelle als Abschlußwiderstände für Sammelleitungen zeigt Fig. 9, Fig. 10 das Ersatzschaltbild dazu. Jetzt wird das Gate des Transistors Tr1 mit der Betriebsspannung VSS verbunden. Die Betriebsspannung VDD ist weiterhin mit der Source Ep1 des Transistors Tr1 verbunden, die Drain Ep2 führt zu einem Verbraucher. Entsprechend ist Transistor Tr2 geschaltet.

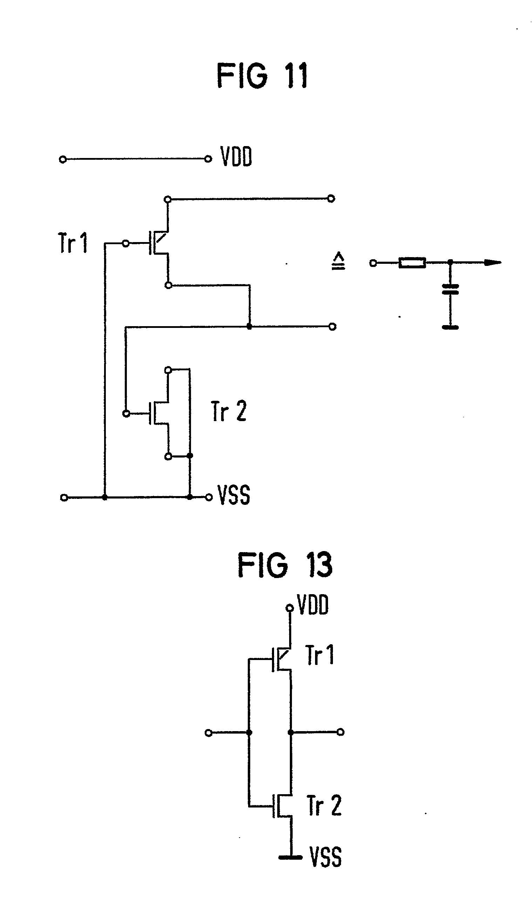

Aus Fig. 11 kann entnommen werden, wie mit Hilfe der Zelle ein RC-Glied geschaffen werden kann. Dazu wird Transistor Tr1 als Widerstand geschaltet, Transistors Tr2 als Kapazität.

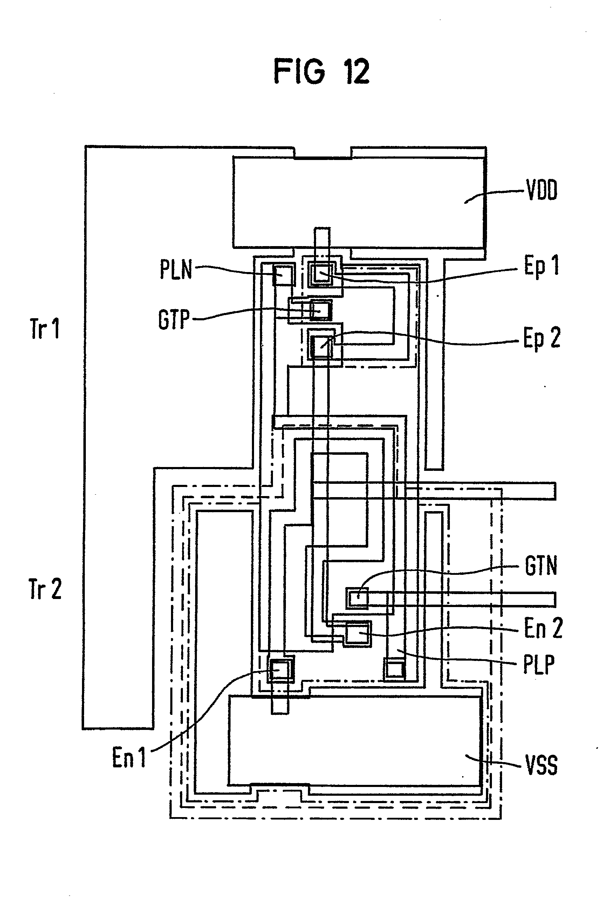

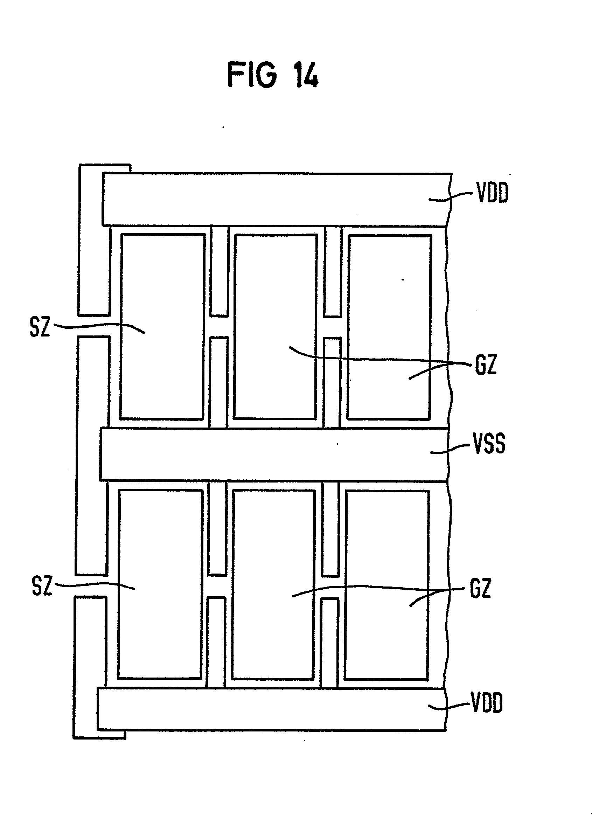

Aus Fig. 12 ergibt sich, wie mit der Zelle ein Inverter realisiert werden kann, der als Schaltglied verwendbar ist. Da die Kanallänge groß ist bei kleiner Kanalweite, ist eine große Schaltzeit erreichbar. Aus dem Ersatzschaltbild der Fig. 13 kann die Verschaltung der Transistoren Tr1 und Tr2 entnommen werden.

Fig. 14 gibt das Layout eines Gate-Arrays an. Es ist zu sehen, wie die Zellen matrixförmig angeordnet sind. An jedem Matrixpunkt kann entweder eine Grundzelle GZ gemäß dem Stand der Technik oder die erfindungsgemäße Zelle SZ angeordnet werden. Es ist jedoch zweckmäßig, die erfindungsgemäßen Zellen SZ am Rande des Gate-Arrays anzuordnen, weil dadurch das Entflechtungsprogramm nicht beeinträchtigt wird.

Die erfindungsgemäße Zelle enthält zwei Transistoren Tr1 und Tr2. Es ist jedoch auch möglich, die Anzahl der Transistoren zu ändern. Weiterhin ist es möglich, die Widerstandswerte bzw. Kapazitätswerte dadurch zu ändern, daß die Kanalbreite und Kanallänge geändert werden.

**Patentansprüche**

1. In CMOS-Technik ausgebaute Zelle, bei der mindestens ein p-Kanal- und mindestens ein n-Kanaltransistor vorgesehen sind, insbesondere zur Verwendung bei einem Gate-Array, dadurch gekennzeichnet, daß der Kanal (KP, KN) jedes Transistors (TR1, TR2) so ausgeführt ist, daß bei schmalem Kanal die Kanallänge groß ist und daß dazu bei jedem Transistor (TR1, TR2) Source und Drain (EP1, EP2 bzw. EN1, EN2) benachbart zueinander liegen und der Kanal (KP bzw. KN) im wesentlichen seitlich zu einer gedachten Verbindungslinie zwischen Source und Drain verläuft.

2. Zelle nach Anspruch 1, dadurch gekennzeichnet, daß zur Realisierung eines Widerstandes der Gate-Anschluß (GTP bzw. GTN) jedes Transistors (Tr1, Tr2) mit einer Betriebsspannung (VSS bzw. VDD) verbunden ist und die Drain- und Source-Anschlüsse (Ep bzw. En) die Widerstandsanschlüsse bilden.

3. Zelle nach Anspruch 1, dadurch gekennzeichnet, daß zur Realisierung einer Kapazität Drain- und Source-Anschluß (Ep bzw. En) der Transistoren (Tr1, Tr2) miteinander verbunden sind und den einen Abschluß der Kapazität bilden, und der Gate-Anschluß (GTP bzw. GTN) den anderen Anschluß der Kapazität bildet.

4. Zelle nach Anspruch 1, dadurch gekennzeichnet, daß zur Realisierung eines Abschlußwiderstandes für eine Sammelleitung der Drain-Anschluß bzw. Source-Anschluß des Transistors (Tr1 bzw. Tr2) mit einer ersten Betriebsspannung (VSS bzw. VDD), der Gate-Anschluß mit einer zweiten Betriebsspannung (VDD bzw. VSS) und der Source- bzw. Drain-Anschluß des Transistors (Tr1 bzw. Tr2) mit der Sammelleitung verbunden sind.

5. Zelle nach Anspruch 1, dadurch gekennzeichnet, daß zur Realisierung eines Schaltzeitgliedes die Transistoren (Tr1, Tr2) als Inverter geschaltet sind.

6. Zelle nach einem der vorhergehenden Ansprüche, dadurch gekennzeichnet, daß die Zelle die gleichen geometrischen Abmessungen wie die Grundzelle des Gate-Arrays hat.

7. Zelle nach einem der vorhergehenden Ansprüche, dadurch gekennzeichnet, daß die Zelle an den Seiten der Grundzellenstreifen des Gate-Arrays angeordnet ist.

## Claims

1. Cell formed by using the CMOS technique, in which at least one p-channel and at least one n-channel transistor are provided, particularly for use in a gate array, characterized in that the channel (KP, KN) of each transistor (TR1, TR2) is constructed in such a manner that, with the channel narrow, the channel length is great, and in that to this end in the case of each transistor (TR1, TR2) source and drain (EP1, EP2 and EN1, EN2 respectively) are adjacent to one another and the channel (KP, KN respectively) essentially extends to the side of an imaginary line connecting source and drain.

2. Cell according to Claim 1, characterized in that, in order to implement a resistor, the gate terminal (GTP and GTN respectively) of each transistor (Tr1, Tr2) is connected to an operating voltage (VSS and VDD respectively), and the drain and source terminals (Ep and En respectively) form the resistor terminals.

3. Cell according to Claim 1, characterized in that, in order to implement a capacitor, drain and source terminal (Ep and En respectively) of the transistors (Tr1, Tr2) are connected to one another and form one terminal of the capacitor, and the gate terminal (GTP and GTN respectively) forms the other terminal of the capacitor.

4. Cell according to Claim 1, characterized in that, in order to implement a terminating resistor for a collective line, the drain terminal or source terminal, respectively, of the transistor (Tr1 or Tr2 respectively) is connected to a first operating voltage (VSS or VDD respectively), the gate terminal is connected to a second operating voltage (VDD or VSS respectively) and the source or drain terminal, respectively, of the transistor (Tr1 or Tr2 respectively) is connected to the collective line.

5. Cell according to Claim 1, characterized in that, in order to implement a switching-type timing element, the transistors (Tr1, Tr2) are connected as inverters.

6. Cell according to one of the preceding claims, characterized in that the cell has the same geometric dimensions as the basic cell of the gate array.

7. Cell according to one of the preceding claims, characterized in that the cell is arranged at the sides of the basic-cell strips of the gate array.

## Revendications

1. Cellule constituée selon la technique CMOS, dans laquelle il est prévu au moins un transistor à canal p et au moins un transistor à canal n, et qui est destinée notamment à être utilisée dans un réseau de grilles (Gate-Array), caractérisée par le fait que le canal (KP, KN) de chaque transistor (TR1, TR2) est agencé de telle sorte que, dans le cas d'un canal étroit, la longueur du canal est importante et qu'à cet effet, dans chaque transistor (TR1, TR2), la source et le drain (EP1, EP2 ou EN1, EN2) sont situés au voisinage l'un de l'autre et que le canal (KP ou KN) s'étend sensiblement latéralement par rapport à une ligne imaginaire de jonction entre la source et le drain.

2. Cellule suivant la revendication 1, caractérisée par le fait que pour la réalisation d'une résistance, la borne de grille (GTP ou GTN) de chaque transistor (Tr1, Tr2) est raccordée une tension de service (VSS ou VDD) et que les bornes de drain et de source (Ep ou En) forment les bornes de la résistance.

3. Cellule suivant la revendication 1, caractérisée par le fait que, pour la réalisation d'une capacité, les bornes de drain et de source (EP ou En) des transistors (Tr1, Tr2) sont reliées entre elles et forment une borne de la capacité, et que la borne de grille (GTP ou GTN) forme l'autre borne de la capacité.

4. Cellule suivant la revendication 1, caractérisée par le fait que pour la réalisation d'une résistance terminale pour une ligne formant bus, la borne de drain ou la borne de source du transistor (Tr1 ou Tr2) est raccordée à une première tension de service (VSS ou VDD), que la borne de grille est raccordée à une seconde tension de service (VDD ou VSS) et que la borne de source ou de drain du transistor (Tr1 ou Tr2) est reliée à la ligne formant bus.

5. Cellule suivant la revendication 1, caractérisée par le fait que pour la réalisation d'un circuit de temporisation de commutation, les transistors (Tr1, Tr2) sont branchés de manière à former un inverseur.

6. Cellule suivant l'une des revendications précédentes, caractérisée par le fait que la cellule possède les mêmes dimensions géométriques que la cellule de base du réseau de grilles (Gate-Array).

7. Cellule suivant l'une des revendications précédentes, caractérisée par le fait que la cellule est disposée sur les côtés de la borne des cellules de base du réseau de grilles (Gate-Array).

# FIG 1

# FIG 2

SKT  PLN  GTP  GO  SKT

SiO₂  SiO₂  SiO₂  SiO₂

n⁺  SiO₂  SiO₂  n⁺

KP

n

SU

# FIG 3

SiO₂  WKT  SiO₂ GO GTN GO  PLP  WKT

SiO₂  SiO₂

p⁺  SiO₂  SiO₂  p⁺

SiO₂  KN  PW

n

SU

# FIG 5

# FIG 4

VDD

Ep 1

Tr 1

Ep 2

En 1

Tr 2

En 2

VSS

# FIG 6

VDD

Ep1

Tr 1

Ep 2

En1

Tr 2

En 2

VSS

# FIG 7

# FIG 9

FIG 8

FIG 10

# FIG 11

VDD

Tr 1

Tr 2

VSS

# FIG 13

VDD

Tr 1

Tr 2

VSS

# FIG 12

# FIG 14